Europäisches Patentamt

European Patent Office

Office européen des brevets

(19)

(11) Publication number : **0 397 945 B1**

(12) **EUROPEAN PATENT SPECIFICATION**

(45) Date of publication of patent specification :
**19.04.95 Bulletin 95/16**

(51) Int. Cl.⁶ : **H03H 11/46**

(21) Application number : **89312001.4**

(22) Date of filing : **20.11.89**

(54) **Variable impedance circuit.**

(30) Priority : **16.05.89 JP 120354/89**

(43) Date of publication of application :
**22.11.90 Bulletin 90/47**

(45) Publication of the grant of the patent :
**19.04.95 Bulletin 95/16**

(84) Designated Contracting States :
**DE FR GB NL**

(56) References cited :
**IEEE JOURNAL ON SOLID-STATE CIRCUITS,
vol. SC-17, no. 4, August 1982, pages713-722,
New York, US; J.O. VOORMAN et al.:
"Integration of analog filters in abipolar pro-
cess"
ELECTRON. APPLIC. BULL., vol. 34, no. 4,
August 1977, pages 148-161, Eindhoven,NL;
"The TCA580 integrated gyrator"**

(73) Proprietor : **MATSUSHITA ELECTRIC
INDUSTRIAL CO., LTD.
1006, Oaza Kadoma
Kadoma-shi, Osaka-fu, 571 (JP)**

(72) Inventor : **Morita, Yoichi
3-320, 300-15 Fuke-cho
Moriyama-shi Shiga (JP)**
Inventor : **Komori, Hiroshi
35-22 Gungeshinmachi
Takatsuki-shi Osaka (JP)**
Inventor : **Yokoyama, Akio
1-27 Choushi 2-chome
Nagaokakyo-shi Kyoto (JP)**

(74) Representative : **Crawford, Andrew Birkby et al
A.A. THORNTON & CO.
Northumberland House
303-306 High Holborn
London WC1V 7LE (GB)**

EP 0 397 945 B1

## Description

This invention relates to a variable impedance circuit capable of electrically increasing or decreasing the impedance such as resistance and capacitance.

Recently, the function of semiconductor integrated circuits has been greatly improved, and the filter circuit has come to be incorporated in a semiconductor chip as an integrated circuit. Generally a filter circuit is composed of resistance element and a capacity element. To change the filtering characteristic of the filter circuit, it is necessary to vary the value of constituent elements, that is, the capacity element or resistance element. Accordingly, hitherto, a variable impedance circuit has been used, which can vary the value of capacity element or resistance element built in a semiconductor chip.

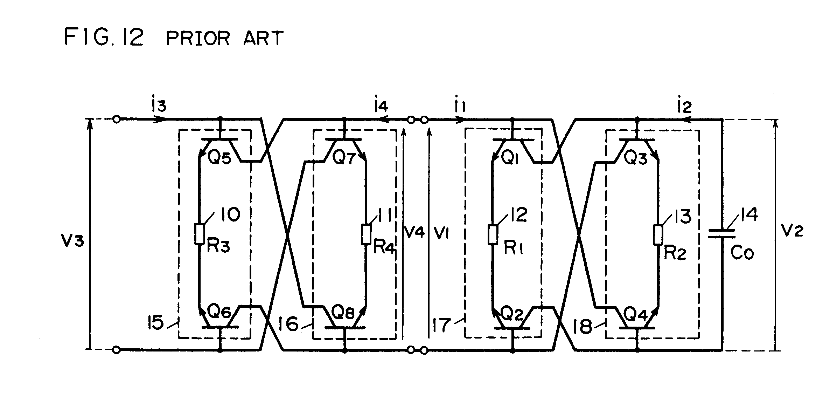

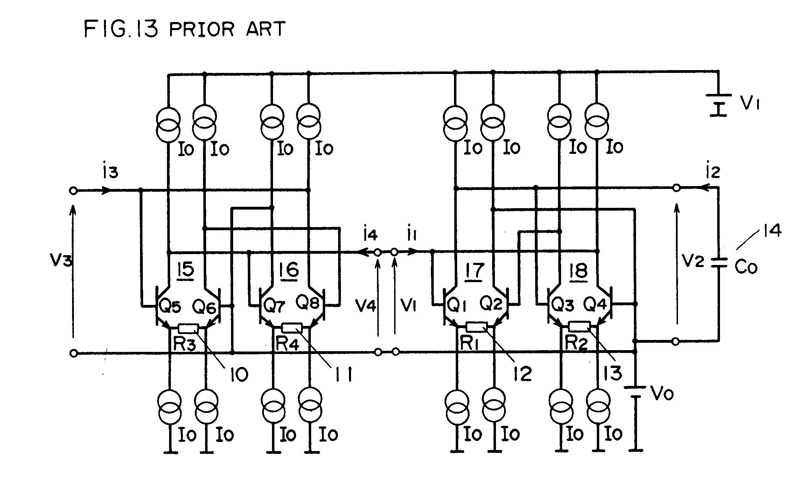

FIG. 12 shows a conventional variable capacity circuit used for such purpose, expressed only by an AC circuit. In FIG. 13, the variable capacity circuit in FIG. 12 is expressed by both AC circuit and DC circuit.

In FIG. 12 and FIG. 13, a differential amplifier circuit 15 is composed of transistors $Q_5$, $Q_6$, and a resistance element 10 connected between their emitters. A differential amplifier circuit 16 is composed of transistors $Q_7$, $Q_8$, and a resistance element 11 connected between their emitters. A differential amplifier circuit 17 is composed of transistors $Q_1$, $Q_2$, and a resistance element 12 connected between their emitters. A differential amplifier circuit 18 is composed of transistors $Q_3$, $Q_4$, and a resistance element 13 connected between their emitters. As clear from FIG. 12 and FIG. 13, the differential amplifier circuits 15, 16 are so connected that the input terminals of one differential amplifier circuit are connected to the output terminals of the other differential amplifier circuit. The differential amplifier circuits 17, 18 are also connected in a similar relation. These differential amplifier circuits 15, 16, 17 and 18 are connected as shown in FIG. 12, FIG. 13, and a capacity element 14 is connected between two output terminals of the differential amplifier circuit 17. The transistors $Q_1$ to $Q_8$ for composing the differential amplifier circuits 15, 16, 17 and 18 are supplied with biases from voltage sources $V_0$, $V_1$, and constant current source $I_0$ as shown in FIG. 13.

The voltage-current conversion factors of the differential amplifier circuits 15, 16, 17 and 18 are determined respectively by the characteristics of the resistance elements 10, 11, 12 and 13.

The operation is explained below.

The relation

$$i_2 = g_1 \cdot V_1 \quad (1)$$

is established between voltage $V_1$ and output current $i_2$ across input terminals of the differential amplifier circuit 17. In this equation $g_1$ denotes the voltage-current conversion factor of the differential amplifier circuit 17, and supposing the emitter resistance value of

transistors $Q_1$, $Q_2$ to be $r_{e1}$, and the value of resistance element 12 between emitters to be $R_1$, it is expressed as follows.

$$g_1 = \frac{1}{R_1 + 2r_{e1}} \quad (2)$$

The characteristics of voltage $V_2$ and current $i_2$ occurring at both ends of the capacity element 14 of capacity value $C_0$ are obtained as follows.

$$i_2 = -j\omega C_0 \cdot V_2 \quad (3)$$

Similarly, the characteristics of voltage $V_2$ across input terminals and output current $i_1$ of the differential amplifier circuit 18 composed of transistors $Q_3$, $Q_4$ are obtained as follows:

$$i_1 = -g_2 \cdot V_2 \quad (4)$$

where $g_2$ denotes the voltage-current conversion factor of the differential amplifier circuit 18, and supposing the resistance value of each emitter of transistors $Q_3$, $Q_4$ to be $r_{e2}$, and the value of the resistance element 13 between the emitters to be $R_2$, it is expressed as follows.

$$g_2 = \frac{1}{R_2 + 2r_{e2}} \quad (5)$$

Solving $V_1$ and $i_1$ from equations (1), (3) and (4), it is known from equations (1), (3) that

$$V_2 = -\frac{g_1 \cdot V_1}{j\omega C_0} \quad (6)$$

and from equations (4), (6) that

$$i_1 = \frac{g_1 \cdot g_2 \cdot V_1}{j\omega C_0} \quad (7)$$

That is,

$$V_1 = j\omega \left(\frac{C_0}{g_1 \cdot g_2}\right) i_1 \quad (8)$$

Here, the inductance L is given as follows.

$$L = \frac{C_0}{g_1 \cdot g_2} \quad (9)$$

Furthermore, from equations (2), (5), it follows that

$$L = (R_1 + 2r_{e1})(R_2 + 2r_{e2}) C_0 \quad (10)$$

Usually, the resistance values can be set so as to establish the relation of $R_1 \gg r_{e1}$, $R_2 \gg r_{e2}$, and hence the inductance L can be approximated as

$$L = R_1 \cdot R_2 \cdot C_0$$

Likewise, the characteristics of input terminal voltage $V_3$ and output current $i_4$ of the differential amplifier circuit 15 composed of transistors $Q_5$, $Q_6$ may be expressed as follows, supposing the voltage-current conversion factor of the differential amplifier circuit 15 to be $g_3$:

$$i_4 = g_3 \cdot V_3 \quad (11)$$

Supposing the voltage-current conversion factor of the differential amplifier circuit 16 to be $g_4$, the characteristics of input terminal voltage $V_4$ and output current $i_3$ of the differential amplifier 16 composed of transistors $Q_7$, $Q_8$ are as follows.

$$i_3 = -g_4 \cdot V_4 \quad (12)$$

The circuit systems respectively composed of the differential amplifier circuits 15, 16, and the differential amplifier circuits 17, 18 represent the conventionally used phase conversion circuits. The circuit system composed of the differential amplifiers 17, 18 is designed to apply from capacity characteristics to inductance characteristics, in terms of circuitry.

In FIG. 12 and FIG. 13, the relations

$$V_4 = V_1 \quad (13)$$
$$i_4 = -i_1 \quad (14)$$

are established between the voltages $V_1$, $V_4$, and currents $i_4$, $i_1$, respectively.

Hence, equation (8) is rewritten as

$$V_4 = j\omega \cdot \frac{C_0}{g_1 \cdot g_2} (-i_4) \quad (15)$$

and further by eliminating $i_4$ from equation (11), it results in

$$V_4 = j\omega \cdot \frac{C_0}{g_1 \cdot g_2} (-g_3 \cdot V_3) \quad (16)$$

and from equations (16) and (12), it follows that

$$i_3 = j\omega \cdot \frac{g_3 \cdot g_4}{g_1 \cdot g_2} C_0 \cdot V_3 \quad (17)$$

The capacity value C applied between the voltage $V_3$ and current $i_3$ is given as

$$C = \frac{g_3 \cdot g_4}{g_1 \cdot g_2} C_0 \quad (18)$$

That is, by properly selecting the values for the voltage-current conversion factors $g_1$, $g_2$, $g_3$ and $g_4$, the capacity value C is newly created electrically.

However, in the conventional variable capacity circuit shown in FIG. 12, FIG. 13, at least four differential amplifier circuits are needed in order to obtain a new capacity value by electrically increasing or decreasing the capacity. Accordingly, the circuit composition is complicated, and the number of required elements increases, and the chip area increases.

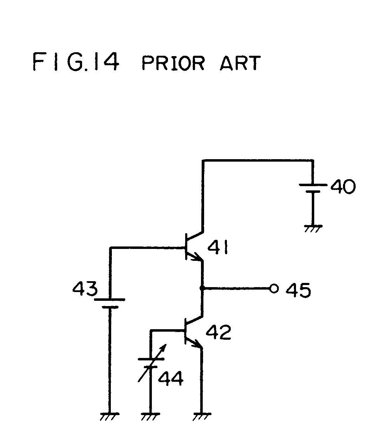

A conventional variable resistance circuit incorporated in a semiconductor chip is explained below while referring to FIG. 14.

In FIG. 14, transistors 41, 42 are connected between a constant voltage source 40 and the grounding potential. A constant voltage source 43 is connected to the base of the transistor 41. A variable voltage source 44 is connected to the base of the transistor 42. An output terminal 45 is connected to the connecting points of the transistors 41, 42.

In the structure in FIG. 14, the resistance value as seen from the output terminal 45 is equal to the differential emitter resistance of the transistor 41 (that is, the impedanace of the transistor 41 seen from its emitter), and it is given in the following formula.

$$\frac{kT/q}{I_0}$$

where k is Boltzmann constant, T is absolute temperature, q is electric charge quantity of an electron, and $I_0$ is emitter current flowing in the transistor 41. When the voltage of the variable voltage source 44 is varied, the current $I_0$ changes, and hence the reistance value as seen from the output terminal 45 varies. Therefore, by controlling the voltage of the variable voltage source 44, a variable resistance may be obtained.

However, in the conventional variable resistance circuit shown in FIG. 14, since the differential emitter resistance itself of the transistor 41 is used as a variable resistance component, the variable range of the resistance value is narrow.

The article "Integration of analog filters in a bipolar process" (J.O. Voorman et al, IEEE Journal of Solid-State Circuits, vol. SC-17, no. 4, August 1982. pp 713-722, New York, US) discloses various transconductor circuits incorporating resistive elements between the emitters of two pairs of transistors, arranged to have the transresistances of a positive or a negative resistor, a gyrator, or a positive or negative inductor, which are suitable as filters of relatively low frequencies without the need for large chip areas.

The article "The TCA 580 Integrated Gyrator" (Electron. Applic. Bull., vol 34, no. 4, August 1977, pp 148-161, Eindhoven, NL) discloses manners in which oscillators and filters of a conventional design can be modified to incorporate TCA 580 inductors instead of conventional would inductors. In particular, a low-frequency oscillator circuit is described incorporating a transconductor circuit similar to that described in the previous paragraph, incorporating resistive elements between the emitters of two pairs of transistors.

According to the present invention, there is provided a variable impedance circuit comprising:

first and second differential amplifier circuits each having a pair of input terminals and a pair of output terminals, each differential amplifier circuit consisting of a pair of active devices, wherein impedance elements are connected between said pairs of active devices, said active devices being transistors or operational amplifiers;

means for connecting the input terminal pair of said first differential amplifier circuit to the output terminal pair of said second differential amplifier circuit; and

means for connecting the input terminal pair of said second differential amplifier circuit to the output terminal of said first differential amplifier circuit; wherein the input terminals of the impedance circuit are connected between the input terminals to the active elements of said first differential amplifier circuit; characterised in that

the impedance elements are either:

a capacitative element in the first differential amplifier circuit and a first resistive element of selectable resistance R in the second differential amplifier circuit; or

a first resistive element of selectable resistance R in the first differential amplifier circuit and a capacitative element in the second differential amplifier circuit;

and characterised in that

a second resistive element of selectable resistance R3 is connected between the input terminals to the active elements of said second differential amplifier circuit;

whereby the impedance of said input terminals is capacitive and is defined by the ratio R3/R of resistance values of said first and second resistive elements.

A second embodiment of the invention is set out in Claim 8.

It is hence a first object of the invention to present a variable impedance circuit capable of varying the impedance, such as capacity value and resistance value, by using two differential amplifier circuits.

It is a second object of the invention to present a variable impedance circuit capable of widening the variable range of impedance such as capacity value and resistance value.

The invention as set out in Claims 1 and 8 is, in short, intended to obtain a new impedance from the voltage and current characteristics caused between the pair of input terminals of a first differential amplifier circuit, by connecting the output terminal pair of the first differential amplifier circuit to the input terminal pair of a second differential amplifier circuit, connecting the output terminal pair of the second differential amplifier cirucuit to the input terminal pair of the first differential amplifier circuit, and connecting an impedance element such as capacity element or resistance element between the emitters of the transistor pair composing the first differential amplifier circuit.

In this way, the variable impedance circuit is composed of two differential amplifier circuits, and the circuit composition may be simplified, and the number of required elements is smaller. Therefore, when this variable impedance circuit is incorporated in a semiconductor chip, the required chip area may become small. Moreover, as compared with the prior art in which differential emitter resistance is directly used as variable resistance component, the variable range of the impedance may be come wider.

FIG. 1 is a circuit diagram expressing a variable impedance circuit in a first embodiment of the invention only by an AC circuit,
FIG. 2 is a circuit diagram expressing the first embodiment by both AC circuit and DC circuit,
FIG. 3 is a circuit diagram expressing a variable impedance circuit in a second embodiment of the invention only by an AC circuit,
FIG. 4 is a circuit diagram expressing the second embodiment by both AC circuit and DC circuit,
FIG. 5 is a circuit diagram expressing a variable impedance circuit in a third embodiment of the invention only by an AC circuit,
FIG. 6 is a circuit diagram expressing the third embodiment by both AC circuit and DC circuit,
FIG. 7 is a circuit diagram expressing a variable impedance circuit in a fourth embodiment of the invention only by an AC circuit,

FIG. 8 is a circuit diagram expressing the fifth embodiment by both AC circuit and DC circuit,
FIG. 9 is a circuit diagram of a variable impedance circuit in a sixth embodiment of the invention modified from the embodiment in FIG. 2, expressed by both AC circuit and DC circuit,
FIG. 10 is a circuit diagram expressing a variable impedance circuit in a seventh embodiment of the invention by both AC circuit and DC circuit,
FIG. 11 is a circuit diagram expressing a variable impedance circuit in an eighth embodiment of the invention by both AC circuit and DC circuit,
FIG. 12 is a circuit diagram expressing a conventional variable capacity circuit only by an AC circuit,
FIG. 13 is a circuit diagram expressing the conventional variable capacity circuit shown in FIG. 12 by both AC circuit and DC circuit, and
FIG. 14 is a circuit diagram showing a conventional variable resistance circuit.

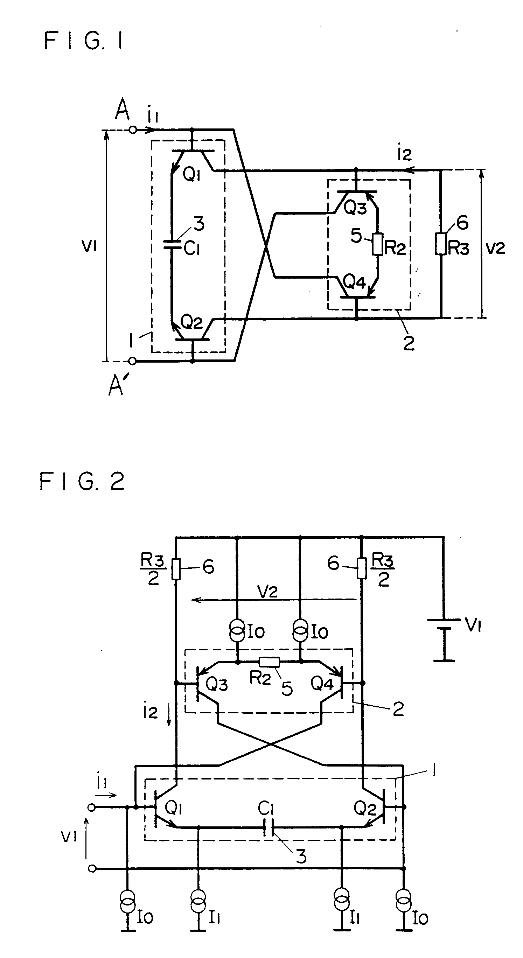

Referring now to FIG. 1 and FIG. 2, a first embodiment of the invention is described in detail below.

In FIG. 1, FIG. 2, a differential amplifier 1 is composed of transistors $Q_1$, $Q_2$, and a capacity element 3 connected between their emitters. A differential amplifier circuit 2 is composed of transistors $Q_3$, $Q_4$, and a resistance element 5 connected between their emitters. The output terminal pair of the differential amplifier circuit 1 is connected to the input terminal pair of the differential amplifier circuit 2. The output terminal pair of the differential amplifier circuit 2 is connected to the input terminal pair of the differential amplifier circuit 1. A resistance element 6 is connected between the input terminals of the differential amplifier circuit 2. Biases are supplied to the transistors $Q_1$ to $Q_4$ from voltage source $V_1$, and constant current sources $I_0$, $I_1$.

The operation is explained below.

Supposing the input terminal AC voltage of the differential amplifier circuit 1 to be $V_1$, and the voltage-current conversion factor of the differential amplifier circuit 1 to be $g_{m1}$, the output AC current $i_2$ is given as

$$i_2 = g_{m1} \cdot V_1 \quad (19)$$

The voltage $V_2$ produced between the both ends of the resistance element 6 of which resistance value is $R_3$ is given as

$$V_2 = - i_2 \cdot R_3 \quad (20)$$

Supposing the voltage-current conversion factor of the differential amplifier circuit 2 to be $g_{m2}$, the output current $i_1$ flowing due to the voltage $V_2$ applied between the input terminals of the differential amplifier circuit 2 is given as

$$i_1 = - g_{m2} \cdot V_2 \quad (21)$$

From equations (19), (20), it follows that

$$V_2 = - g_{m1} \cdot R_3 \cdot V_1 \quad (22)$$

From equations (22), (21), it follows that

$$i_1 = g_{m1} \cdot g_{m2} \cdot R_3 \cdot V_1 \quad (23)$$

Here, the voltage-current conversion factor $g_{m2}$ of the differential amplifier circuit 2 is given by the resistance characteristic. In other words, the voltage-current conversion factor $g_{m2}$ is determined by the emitter resistance value $r_{e2}$ of transistors $Q_3$, $Q_4$ and the resistance value $R_2$ of the resistance element 5, and is obtained as follows.

$$g_{m2} = \frac{1}{R_2 + 2r_{e2}}$$

Supposing here $r_{e2} \ll R_2$, it follows that

$$g_{m2} = \frac{1}{R_2} \quad (24)$$

Next, the voltage-current conversion factor $g_{m1}$ of the differential amplifier circuit 1 is given by the characteristics of the capacity element 3. Here, the voltage-current conversion factor $g_{m1}$ is given by the impedance of the capacity element 3

$$Z = \frac{1}{j\omega C_1}$$

and the emitter resistance value $r_{e1}$ of the transistors $Q_1$, $Q_2$, and it becomes

$$g_{m1} = \frac{1}{Z + 2r_{e1}}$$

Here, if selecting as $2r_{e1} \ll |Z|$, it follows that

$$g_{m1} = \frac{1}{Z} \quad (25)$$

$$= j\omega C_1 \quad (26)$$

Putting equations (24), (26) into equation (23) yields

$$i_1 = j\omega C_1 \cdot \frac{R_3}{R_2} \cdot V_1 \quad (27)$$

As a result, between the voltage $V_1$ and current $i_1$, a new capacity value C is given as

$$C = \frac{R_3}{R_2} \cdot C_1 \quad (28)$$

By selecting the ratio of the resistance value $R_3$ and $R_2$, another new capacity value C may be obtained from the original capacity value $C_1$.

Besides, as seen from equation (23), it is enough when the capacity characteristic is given to either one of the voltage-current conversion factor $g_{m1}$ or $g_{m2}$.

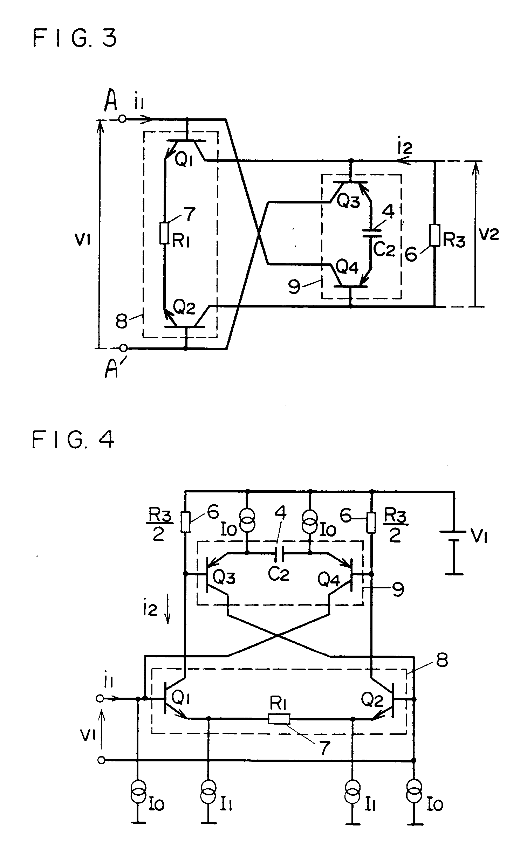

FIG. 3 and FIG. 4 relate to a second embodiment of the invention. The variable impedance circuit shown in FIG. 3, FIG. 4 comprises differential amplifier circuits 8, 9, and a resistance element 7 is connected between the emitters of transistors $Q_1$, $Q_2$ for composing the differential amplifier circuit 8, and a capacity element 4 is connected between the emitters of transistors $Q_3$, $Q_4$ for composing the differential amplifier circuit 9. The other composition is same as in the first embodiment shown in FIG. 1, FIG. 2.

Now, assuming the capacity value of the capacity element 4 to be $C_2$ and the resistance value of the resistance element 7 to be $R_1$, equations (26), (24) in the first embodiment are respectively rewritten as

$$g_{m2} = j\omega C_2 \quad (29)$$

$$g_{m1} = \frac{1}{R_1} \quad (30)$$

and the current $i_1$ becomes

$$i_1 = j\omega C_2 \cdot \frac{R_3}{R_1} \cdot V_1 \quad (31)$$

That is, same as in the first embodiment, a new capacity value C is applied between the voltage $V_1$ and current $i_1$ as

$$C = \frac{R_3}{R_1} \cdot C_2$$

Therefore, by selecting the ratio of the resistance value $R_3$ and $R_1$, a new capacity value C may be obtained from the initial capacity value $C_2$.

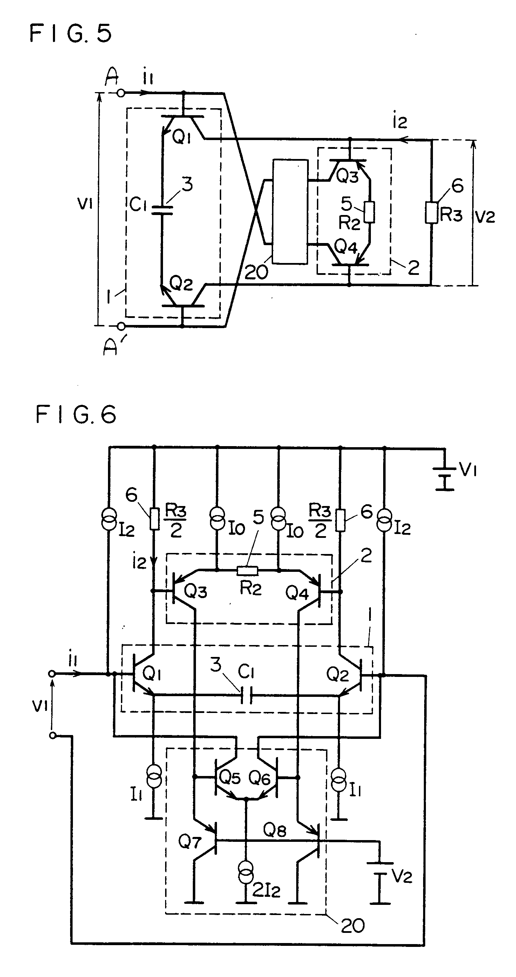

FIG. 5 and FIG. 6 relate to a third embodiment of the invention. In this embodiment, as clearly seen from FIG. 5, the output terminal pair of the differential amplifier circuit 2 is connected to the input terminal pair of the differential amplifier circuit 1 by way of a current-current conversion circuit 20. The current-current conversion circuit 20 may be realized, for example as shown in FIG. 6, by a known Gilbert multiplication circuit composed of transistors $Q_5$ to $Q_8$, and current source $2I_2$. Meanwhile, to the transistors $Q_7$, $Q_8$ of the current-current conversion circuit 20, a base bias is applied from a voltage source $V_2$. The other composition is substantially same as in FIG. 2, FIG. 4.

When such current-current conversion circuit 20 is used, the current value of the differential amplifier circuit 2 may be varied independently of the composition of the differential amplifier circuit 2. In other words, supposing there is a coefficient K for converting current $i_1$ into other current $i_1'$, the relation is

$$i_1' = K \cdot i_1 \quad (32)$$

Putting equation (32) into equation (27), the converted current $i_1'$ is expressed as

$$i_1' = K \cdot j\omega C_1 \frac{R_3}{R_2} \cdot v_1 \quad (33)$$

Therefore, the capacity value $C'$ after conversion is

$$C' = K \frac{R_3}{R_2} C_1 \quad (34)$$

As known from equation (34), the new capacity value $C'$ may be increased or decreased by the quantity given as the product of K and $R_3/R_2$. Since K is determined by $I_2/I_0$, equation (34) is finally rewritten as

$$C' = \frac{I_2}{I_0} \cdot \frac{R_3}{R_2} \cdot C_1 \quad (35)$$

That is, according to the embodiment in FIG. 6, the capacity value can be changed not only by the ratio of resistance components ($R_3/R_2$), but also by the ratio of current components ($I_2/I_0$). Therefore, a greater capacity value may be obtained.

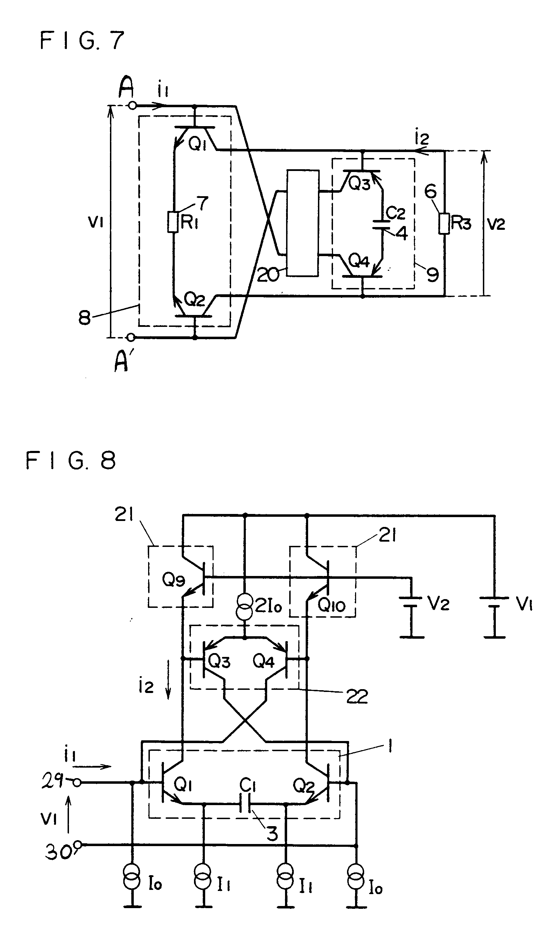

FIG. 7 shows a fourth embodiment of the invention, having a current-current conversion circuit 20 added to the embodiment in FIG. 3. In FIG. 7, too, the current value of the differential amplifier circuit 9 may be varied independently of the composition of the differential amplifier circuit 9. In FIG. 7, the capacity value $C'$ after conversion is given as

$$C' = K \frac{R_3}{R_1} C_2$$

When the current-current conversion circuit 20 is used as shown in the embodiments in FIG. 5 to FIG. 7, the following advantages are brought about. Since the resistance element and capacity element of the variable impedance circuit of the invention are formed in a semiconductor chip, their values are fixed. But when actually composing a filter circuit by using this variable impedance circuit, it may be sometimes desired to vary the frequency characteristics of the filter only very slightly. In such a case, by using the current-current conversion circuit 20, the filter circuit may be furnished with a kind of a variable resistor function, so that a desired frequency characteristic may be realized quite easily.

FIG. 8 shows a fifth embodiment of the invention modifying the embodiment in FIG. 6. That is, instead of the linear resistance elements 6, 6 in FIG. 6, nonlinear characteristic resistances 21, 21 composed of transistors $Q_9$, $Q_{10}$ are used, and a base bias is applied to these transistors $Q_9$, $Q_{10}$ from a voltage source $V_2$. Meanwhile, in the composition in FIG. 8, resistance element is not connected between the emitters of the transistors $Q_3$, $Q_4$ for composing a differential amplifier circuit 22.

In the embodiment in FIG. 8, the transistors $Q_9$, $Q_{10}$, the transistors $Q_3$, $Q_4$ for composing the differential amplifier circuit 22, and the current source $2I_0$ fulfill substantially an equivalent current-current converting function as the Gilbert multiplication circuit 20 shown in FIG. 6. Accordingly, the current-current converting function is realized in a simple circuit structure. What is more, when composed as shown in FIG. 8, since the base potentials of the transistors $Q_9$, $Q_{10}$ are fixed by the potential of the voltage source $V_2$, the emitter potentials of the transistors $Q_3$, $Q_4$ for composing the differential amplifier circuit 22 are also fixed nearly at specific potentials. Therefore, particularly when the supply voltage is small, the circuit design becomes quite easy, and the dynamic range of the transistors $Q_1$, $Q_2$ for composing the differential amplifier circuit 1 may be widened.

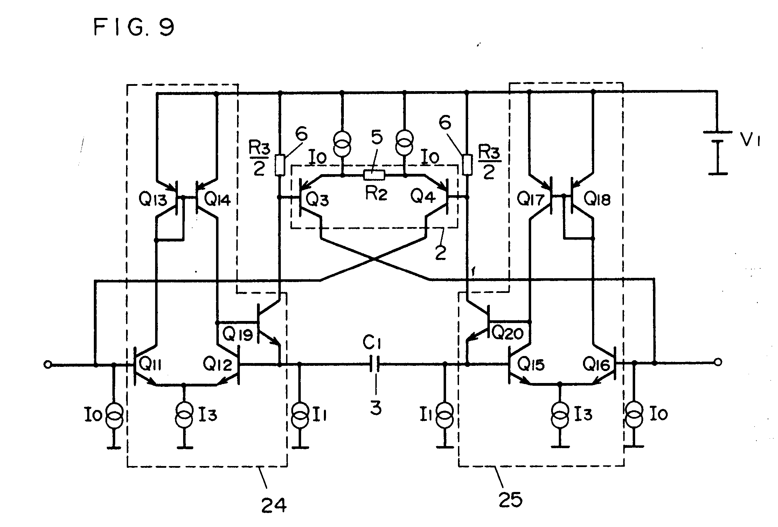

FIG. 9 shows a sixth embodiment of the invention, improving the embodiment in FIG. 2. Instead of the transistor $Q_1$ in FIG. 2, an operational amplifier 24 is used, and instead of transistor $Q_2$ in FIG. 2, an operational amplifier 25 is used. The operational amplifier 24 is composed of transistors $Q_{11}$ to $Q_{14}$, $Q_{19}$, and a current source $I_3$, while the operational amplifier 25 is composed of transistors $Q_{15}$ to $Q_{18}$, $Q_{20}$, and a current source $I_3$.

By thus composing, the emitter resistances of the transistors $Q_{19}$, $Q_{20}$ become smaller in reverse proportion to the open gain of the operational amplifiers 24, 25. As a result, the resistance component added serially to the capacity element 3 is decreased.

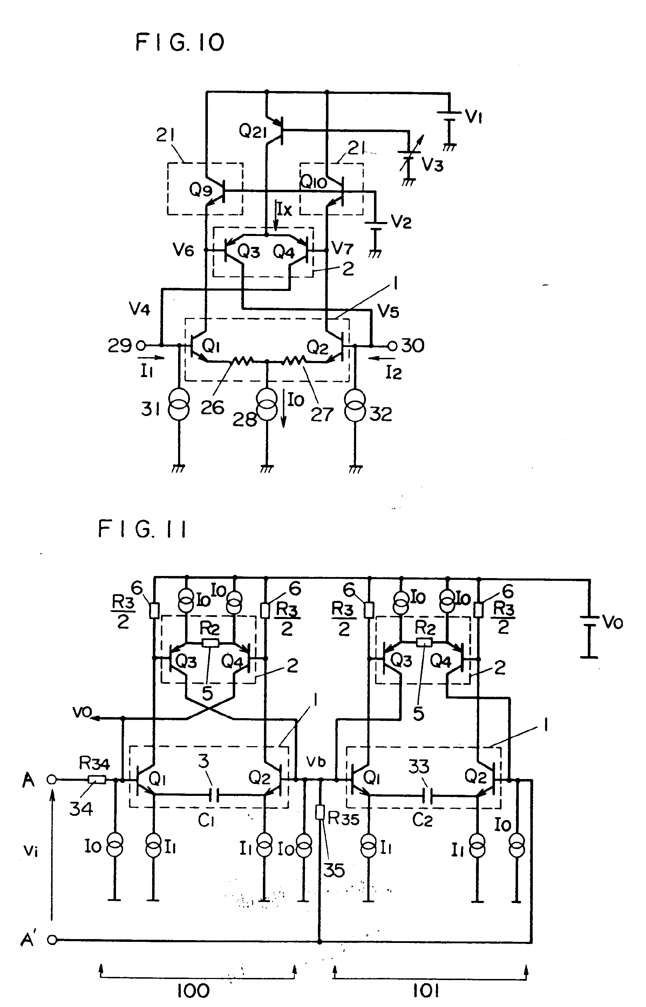

FIG. 10 shows an embodiment of the invention applied to a variable resistance circuit.

The embodiment in FIG. 10 is a modified version of the composition of FIG. 8, and the same parts are identified with the same reference numbers and repeated explanations are omitted. A transistor $Q_{21}$ and a variable voltage source $V_3$ make up a current source, and an electric current $I_x$ is supplied into the differential amplifier circuit 2. On the other hand, resistance element 26, 27 are connected in series between the emitters of the transistors $Q_1$, $Q_2$ for composing the differential amplifier circuit 1, and a constant current source 28 is connected between their connecting point and the reference potential.

Supposing the current flowing in the constant current source 28 to be $I_0$, the differential emitter resistance $r_{eN}$ of the transistros $Q_1$, $Q_2$, $Q_9$ and $Q_{10}$ is expressed as follows:

$$r_{eN} = (KT/q) / (I_0/2) \quad (36)$$

where K is Boltzmann's constant, T is absolute temperature, and q is electric charge quantity of an electron. The potentials applied to input terminals 29 and 30 are supposed to be $V_4$ and $V_5$. When the potentials $V_4$ and $V_5$ are changed, the emitter current flowing in the transistors $Q_1$ and $Q_2$ varies. At the same time, the emitter current flowing in the transistors $Q_9$ and $Q_{10}$ varies, and accordingly the potentials $V_6$ and $V_7$ of the emitters of the transistors $Q_9$ and $Q_{10}$ are also changed. At this time, the rate of change of voltage $(V_7-V_6)$ to the voltge $(V_4-V_5)$, that is, the voltage amplification factor $G_N$ is given in the following equation:

$$G_N = d(V_6 - V_7) / d(V_4 - V_5) = r_{eN} / (r_{eN} + R)$$
$$(37)$$

where R is the resistance value of resistance elements 26 and 27, and it functions to increase the emitter series resistance of the transistors $Q_9$ and $Q_{10}$. supposing the collector current of the transistor $Q_{21}$ to be $I_x$, each emitter current and collector current of the transistors $Q_3$ and $Q_4$ are $I_x/2$. Therefore, the differential emitter resistance $r_{ep}$ of the transistors $Q_3$ and $Q_4$ is given as follows:

$$r_{er} = (KT/q) / (I_x/2) \quad (38)$$

At this time, when the current value flowing in the constant current sources 31 and 32 is set at $I_x/2$, the current flowing in from the input terminals 29 and 30 becomes zero, which is very convenient. The rate of change of collector currents of the transistors $Q_3$ and $Q_4$ by the change of the voltage $(V_7-V_6)$ generated between the bases of the transistors $Q_3$ and $Q_4$, that is, the voltage-current conversion factor (mutual conductance) $g_{mp}$ is given as follows.

$$g_{mp} = 1 / r_{ep} \quad (39)$$

The change of the collector current of transistors $Q_3$ and $Q_4$ is equal to the change of the currents $I_1$ and $I_2$ flowing in from the input terminals 29 and 30. Therefore, the rate of change of currents $I_1$ and $I_2$ by the changes of the potentials $V_4$ and $V_5$, $d(I_1-I_2) / d(V_4-V_5)$, is given as follows.

$$d(I_1 - I_2)/d(V_4 - V_5) = g_{mp} \cdot G_N$$
$$= r_{eN}/ \{(r_{eN} + R) \cdot r_{ep}\} \quad (40)$$

Futhermore, since the change of current $I_1$ and change of current $i_2$ are equal to each other, the resistance value seen from the input terminals 29 and 30, $d(V_4-V_5)/dI_1$ is expressed as follows.

$$d(V_4 - V_5)/dI_1 = d(V_4 - V_5)/\frac{1}{2} d(I_1 - I_2)$$
$$= \{2(r_{eN} + R)/r_{eN}\}r_{ep} \quad (41)$$

As known from the equation (41), the value of the resistance is equal to the product of the differential emitter resistance $r_{ep}$ of transistors $Q_3$ and $Q_4$ multiplied by the coefficient $\{2(r_{eN}+R) / r_{eN}\}$. Here, since, the resistance value R of the resistances 26 and 27 is a positive value, the coefficient $\{2(r_{eN}+R) / r_{eN}\}$ is greater than 2. To change the resistance value seen from the input terminals 29 and 30, meanwhile, the voltage value of the variable voltage source $V_3$ is changed and the collector current $I_x$ of the transistor $Q_{21}$ is changed, thereby causing to vary the differential emitter resistance $r_{ep}$.

According to the embodiment in FIG. 10, as compared with the variation width of the differential emitter resistance $r_{ep}$, the resistance value can be varied in a width of more than twice as much.

In the embodiment shown in FIG. 10, meanwhile, the collector of the transistor $Q_3$ is connected to the base of the transistor $Q_2$, and the collector of the transistor $Q_4$ is connected to the base of the transistor $Q_1$, but instead the collectors of the transistors $Q_3$ and $Q_4$ may be mutually exchnaged. In this case, as the resistance value seen from the input terminals 29 and 30, a negative resistance may be realized. Moreover, in the embodiment in FIG. 10, the transistors $Q_9$ and $Q_{10}$ are used as the resistive load of the transistors $Q_1$ and $Q_2$, but it is also possible, needless to say, to use an ordinary resistance element as shown in FIG. 2.

Thus, according to the embodiment in FIG. 10, the resistance value can be changed in a broader width than the variation of the differential emitter resistance of a transistor, and the variable width of the resistance value can be freely changed by changing the current value of the current source connected to the transistor pair of the differential amplifier circuit.

FIG. 11 relates to an eighth embodiment of the invention. In FIG. 11, variable capacity circuits 100, 101 substantially equivalent to the composition shown in FIG. 2 are connected in cascade. A capacity element 33 is connected between the emitters of the transistors $Q_1$, $Q_2$ for composing the differential amplifier circuit 1 of the variable capacity circuit 101. The capacity value of this capacity element 33 is supposed to be $C_2$. The resistance value of the resistance element 34 connected to the base of the transistor $Q_1$ of the variable capacity circuit 100 is supposed to be $R_{34}$, and the resistance value of the resistance element 35 connected between the reference potential and the base of the transistor $Q_2$ of the variable capacity circuit 100 is supposed to be $R_{35}$. The rest of the composition is same as in FIG. 2.

This embodiment is intended to obtain a large (infinite, theoretically) capacity on the basis of the following principle.

Supposing the capacity values of two capacity elements to be $-C_A$, $C_B$, and the synthetic capacity value by connecting them in series to be C, the following relation is obtained.

$$\frac{1}{j\omega C} = - \frac{1}{j\omega C_A} + \frac{1}{j\omega C_B} = \frac{1}{j\omega \dfrac{C_A \cdot C_B}{C_A - C_B}} \quad (42)$$

Therefore, it follows that

$$C = \frac{C_A \cdot C_B}{C_A - C_B} \quad (43)$$

and when $C_A = C_B$, C is infinite. Generally, in a semiconductor integrated circuit, since the relative precision of elements is extremely high, when the circuit is designed so that, for example, $C_A = 1.01 C_B$, C is

$$C = \frac{1.01 C_B^2}{0.01 C_B} = 101 C_B \quad (44)$$

and a capacity value of over 100 times will be easily obtained. By the same principle, a negative capacity may be realized.

Next, according to the composition in FIG. 11, its operation is explained below.

Supposing the base AC voltage of the transistor $Q_1$ of the variable capacity circuit 100 to be $V_o$, and the base AC voltage of the transistor $Q_2$ to be $V_b$, they are

$$V_o = V_i - j\omega C_1 R_{34} \cdot \frac{\dfrac{R_3}{2} + \dfrac{R_3}{2}}{R_2} (V_o - V_b) \quad (45)$$

$$V_b = j\omega C_1 R_{35} \cdot \frac{\dfrac{R_3}{2} + \dfrac{R_3}{2}}{R_2} (V_o - V_b)$$
$$+ j\omega C_2 R_{35} \cdot \frac{\dfrac{R_3}{2} + \dfrac{R_3}{2}}{R_2} \cdot V_b \quad (46)$$

Here, assuming the two variable capacity circuits 100, 101 to be symmetrical, and $R_2 = R_3$, from equations (45), (46), it follows that

$$V_b = \frac{j\omega C_1 R_{35}}{1 + j\omega(C_1 - C_2)R_{35}} V_o \quad (47)$$

Putting equation (47) into equation (45) yields

$$V_o = \frac{1 + j\omega(C_1 - C_2)R_{35}}{1 + j\omega(C_1 - C_2)R_{35} - \omega^2 C_1 C_2 R_{34}R_{35}} V_i \quad (48)$$

From equation (48), it is found that

$$f_o = \frac{1}{2\Pi\sqrt{C_1 C_2 R_{34}R_{35}}} \quad (49)$$

$$Q = \frac{1}{\sqrt{\dfrac{1}{C_1 C_2}} \cdot \dfrac{R_{35}}{R_{34}} \cdot (C_1 - C_2)} \quad (50)$$

Therefore, when $C_1 = C_2$, Q is infinite, and a secondary low pass filter with an extremely high selectivity will be realized.

On the other hand, when the resistance value $R_{35}$ is an extremely large value, it results in

$$V_o = \frac{\dfrac{1}{R_{35}} + j\omega\,(C_1 - C_2)}{\dfrac{1}{R_{35}} + j\omega(C_1 - C_2) + (j\omega)^2 C_1 C_2 R_{34}} \, V_i$$

$$= \frac{1}{1 + j\omega \dfrac{C_1 \cdot C_2}{C_1 - C_2} R_{34}} \, V_i \quad (51)$$

Hence, when $C_1 = C_2$, a primary low pass filter having equivalently an extremly large capacity value

$$C = \frac{C_1 \cdot C_2}{C_1 - C_2}$$

may be realized.

Along with the advancement in the degree of integration of semiconductor integrated circuit, it is demanded to incorporate external parts, in particular, capacity elements with large capacity into a semiconductor chip. Generally, in a semiconductor integrated circuit, the relative precision of elements such as capacities, resistance and transistors is extremely high, and therefore it is quite easy to set the capacity values $C_1$, $C_2$ of the two capacity elements 3 and 33 in FIG. 11 nearly equal to each other (for example, $C_1 = 1.01 \, C_2$). Therefore, hitherto, within the semiconductor chip, it was bound to realize a capacity value of only about 100 pF from economical point of view, while, by contrast, in the composition as shown in FIG. 11, an extremely large capacity value may be realized in a semiconductor integrated circuit.

**Claims**

1.  A variable impedance circuit comprising:

    first and second differential amplifier circuits (1,2,8,9) each having a pair of input terminals and a pair of output terminals, each differential amplifier circuit consisting of a pair of active devices (Q1, Q2; Q3, Q4; 24, 25), wherein impedance elements (3, 4, 5, 7) are connected between said pairs of active devices, said active devices being transistors or operational amplifiers;

    means for connecting the input terminal pair of said first differential amplifier circuit (1, 8) to the output terminal pair of said second differential amplifier circuit (2, 9); and

    means for connecting the input terminal pair of said second differential amplifier circuit (2, 9) to the output terminal of said first differential amplifier circuit (1, 8); wherein

    the input terminals (A,A') of the impedance circuit are connected between the input terminals to the active elements of said first differential amplifier circuit (1, 8);

    characterised in that

    the impedance elements are either:

a capacitative element (3) in the first differential amplifier circuit (1, 8)) and a first resistive element (5) of selectable resistance R in the second differential amplifier circuit (2, 9); or

a first resistive element (7) of selectable resistance R in the first differential amplifier circuit (1, 8) and a capacitative element (4) in the second differential amplifier circuit (2, 9);

and characterised in that

a second resistive element (6) of selectable resistance R3 is connected between the input terminals to the active elements of said second differential amplifier circuit (2, 9);

whereby the impedance of said input terminals is capacitative and is defined by the ratio R3/R of resistance values of said first and second resistive elements.

2.  A variable impedance circuit according to claim 1 wherein said active devices of said first differential amplifier circuit are operational amplifiers.

3.  A variable impedance circuit according to claim 1 wherein said pairs of devices of said first and second differential amplifier circuits are pairs of transistors (Q1, Q2; Q3, Q4).

4.  A variable impedance circuit according to claim 3 wherein said impedance elements (3, 4, 5, 7) are connected between the emitters of said pairs of transistors (Q1, Q2; Q3, Q4).

5.  A variable impedance circuit according to any of the previous claims wherein

    a first constant current source for supplying selectable current I0 is connected between the pair of active devices of said second differential amplifier circuit.

6.  A variable circuit according to claim 5, wherein a current-current conversion circuit (20) is connected between the first and second differential amplifier circuits (1,2), said current-current conversion circuit comprising a third differential amplifier circuit consisting of a pair of transistors (Q5, Q6) and a second constant current source for supplying selectable current I2 connected to the common emitter of said pair of transistors (Q5, Q6) of said third differential amplifier circuit, the bases of the transistors of the third differential amplifier circuit being connected to the output terminal pair of the second differential amplifier circuit (2), and the collectors of the transistors of the third differential amplifier circuit being connected to the input terminal pair of the first differential amplifier circuit (1);

    whereby the impedance of the input terminal of the impedance circuit is defined by the ratio of resistance values (R3/R) of said first and second resistive elements and by the ratio of the current values (I2/IO) of said first and second constant current sources.

7. A variable impedance arrangement comprising first and second variable impedance circuit (100, 101) each according to any of the preceding claims, further comprising means for connecting the input terminal of one of the active devices (Q1, Q2) of the first differential amplifier circuit (1) of said first variable impedance circuit (100) to the input terminal of one of the active devices (Q1, Q2) of the first differential amplifier circuit (1) of said second variable impedance circuit (101).

8. A variable impedance circuit comprising:
first and second differential amplifier circuits (1; 2, 22) each consisting of a pair of transistors (Q1, Q2; Q3, Q4) and having a pair of input terminals and a pair of output terminals;
means for connecting the input terminal pair of said first differential amplifier circuit (1) to the output terminal pair of said second differential amplifier circuit (2, 22); and
means for connecting the input terminal pair of said second differential amplifier circuit (2, 22) to the output terminal pair of said first differential amplifier (1);
wherein the input terminals of the impedance circuit are connected between the base terminals of the transistors (Q1, Q2) of the first differential amplifier circuit;
characterised in that said circuit further comprises an impedance element (3, 33; 26, 27) connected between the emitters of the transistors of said first differential amplifier circuit (1);
a first constant current source (Io, Ix) for supplying a selectable current, connected between a common emitter for the transistors of said second differential amplifier circuit (2, 22) and a first voltage source (V1)
a transistor (Q9, Q10) connected between each input terminal of said second differential amplifier circuit (2) and the first voltage source (V1), wherein a base bias is supplied to each of said transistors (Q9, Q10) from a second voltage source (V2, V3).

9. A variable impedance circuit according to claim 8, wherein:
said impedance element is a capacitive element (3);
said first constant current source is adapted to supply selectable current Io to the common emitter of the transistors of said second differential amplifier circuit (22); and

a second constant current source is adapted to supply selectable current I1 between the emitters of the transistors of said first differential amplifier circuit (1);
whereby the impedance of said input terminal of the impedance circuit can be changed in proportion to the ratio of the current values Io and I1 of the first and second constant current sources.

10. A variable impedance circuit according to claim 8, wherein:
said impedance element is a resistive element (26, 27);
said first constant current source is adapted to supply selectable current Ix to the common emitter of the transistors of said second differential amplifier circuit (2); and
a second constant current source is adapted to supply selectable current Io between the emitters of the transistors of the first differential amplifiers circuit (1);
whereby the impedance of the input terminal of the impedance circuit can be changed in proportion to the ratio of the current values Ix and Io of the first and second constant current sources.

## Patentansprüche

1. Variable Impedanz-Schaltung, welche umfaßt:
erste und zweite Differentialverstärker-Schaltungen (1, 2, 8, 9) mit jeweils einem Paar Eingangsklemmen und einem Paar Ausgangsklemmen, wobei jede Differentialverstärker-Schaltung aus einem Paar aktiver Bauelemente ($Q_1$, $Q_2$; $Q_3$, $Q_4$; 24, 25) besteht, Impedanzelemente (3, 4, 5, 7) zwischen den Paaren aktiver Bauelemente angeschlossen sind und die aktiven Bauelemente Transistoren oder Operationsverstärker sind;
Mittel zum Verbinden des Eingangsklemmen-Paares der ersten Differentialverstarker-Schaltung (1, 8) mit dem Ausgangsklemmen-Paar der zweiten Differentialverstärker-Schaltung (2, 9); und
Mittel zum Verbinden des Eingangsklemmen-Paares der zweiten Differentialverstärker-Schaltung (2, 9) mit der Ausgangsklemme der ersten Differentialverstärker-Schaltung (1, 8); wobei die Eingangsklemmen (A, A') der Impedanz-Schaltung zwischen den Eingangsklemmen zu den aktiven Elementen der ersten Differentialverstarker-Schaltung (1, 8) angeschlossen sind;
**dadurch gekennzeichnet,**
daß die Impedanz-Elemente entweder:
ein kapazitives Element (3) in der ersten Differentialverstarker-Schaltung (1,8) und ein erstes Widerstandselement (5) von auswahlbarem Widerstandswert R in der zweiten Differentialverstarker-Schaltung (2, 9); oder

ein erstes Widerstandselement (7) von auswählbarem Widerstandswert R in der ersten Differentialverstärker-Schaltung (1, 8) und ein kapazitives Element (4) in der zweiten Differentialverstärker-Schaltung (2, 9) sind; und **dadurch gekennzeichnet,**

daß ein zweites Widerstandselement (6) von auswählbarem Widerstandswert $R_3$ zwischen den Eingangsklemmen der aktiven Elemente der zweiten Differentialverstarker-Schaltung (2, 9) angeschlossen ist;

wodurch die Impedanz der Eingangsklemmen kapazitiv und durch das Verhältnis $R_3/R$ der Widerstandswerte des ersten und des zweiten Widerstandselements bestimmt ist.

2. Variable Impedanz-Schaltung nach Anspruch 1, bei der die aktiven Bauelemente der ersten Differentialverstärker-Schaltung Operationsverstarker sind.

3. Variable Impedanz-Schaltung nach Anspruch 1, bei der die Paare von Bauelementen der ersten und zweiten Differentialverstärker-Schaltungen Transistorpaare ($Q_1$, $Q_2$; $Q_3$, $Q_4$) sind.

4. Variable Impedanz-Schaltung nach Anspruch 3, bei der Impedanzelemente (3, 4, 5, 7) zwischen den Emittern der Transistorpaare ($Q_1$, $Q_2$; $Q_3$, $Q_4$) angeschlossen sind.

5. Variable Impedanz-Schaltung nach einem der vorangehenden Ansprüche, bei der eine erste Konstantstromquelle zum Zuführen eines wählbaren Stromes $I_0$ zwischen dem Paar aktiver Bauelemente der zweiten Differentialverstärker-Schaltung angeschlossen ist.

6. Variable Impedanz-Schaltung nach Anspruch 5, bei der ein Strom/Strom-Wandlerkreis (20) zwischen den ersten und zweiten Differentialverstärker-Schaltungen (1, 2) angeschlossen ist, welcher Strom/Strom-Wandlerkreis umfaßt eine dritte Differentialverstärker-Schaltung, bestehend aus einem Transistoren-Paar ($Q_5$, $Q_6$) und einer zweiten Konstantstromquelle zum Zuführen eines wählbaren Stroms $I_2$, die an dem gemeinsamen Emitter des Transistorenpaares ($Q_5$, $Q_6$) der dritten Differentialverstarker-Schaltung angeschlossen ist, wobei die Basisanschlüsse der Transistoren der dritten Differentialverstärker-Schaltung mit dem AusgangsklemmenPaar der zweiten Differentialverstarker-Schaltung (2) verbunden sind, und die Kollektoren der Transistoren der dritten Differentialverstärker-Schaltung mit dem Eingangsklemmen-Paar der ersten Differentialverstärker-Schaltung (1) verbunden sind;

wodurch die Impedanz der Eingangsklemmen der Impedanz-Schaltung definiert wird durch das Verhältnis der Widerstandswerte ($R_3/R$) des ersten und des zweiten Widerstandselementes und durch das Verhältnis der Stromwerte ($I_2/I_0$) der ersten und der zweiten Konstantstromquelle.

7. Variable Impedanz-Anordnung, welche erste und zweite variable Impedanz-Schaltungen (100, 101) jeweils nach einem der vorangehenden Ansprüche umfaßt, und weiter umfaßt Mittel zum Verbinden der Eingangsklemme eines der aktiven Bauelemente ($Q_1$, $Q_2$) der ersten Differentialverstärker-Schaltung (1) der ersten variablen Impedanz-Schaltung (100) mit der Eingangsklemme eines der aktiven Bauelemente ($Q_1$, $Q_2$) der ersten Differentialverstärker-Schaltung (1) der zweiten variablen Impedanz-Schaltung (101).

8. Variable Impedanz-Schaltung, welche umfaßt: erste und zweite Differentialverstärker-Schaltungen (1; 2, 22), die jeweils aus einem Paar Transistoren ($Q_1$, $Q_2$; $Q_3$, $Q_4$) bestehen und ein Paar Eingangsklemmen und ein Paar Ausgangsklemmen besitzen;

Mittel zum Verbinden des Eingangsklemmen-Paares der ersten Differentialverstärker-Schaltung (1) mit dem Ausgangsklemmen-Paar der zweiten Differentialverstärker-Schaltung (2, 22); und

Mittel zum Verbinden des Eingangsklemmen-Paares der zweiten Differentialverstärker-Schaltung (2, 22) mit dem Ausgangsklemmen-Paar der ersten Differentialverstärker-Schaltung (1);

wobei die Eingangsklemmen der Impedanz-Schaltung zwischen den Basisanschlüssen der Transistoren ($Q_1$, $Q_2$) der ersten Differentialverstärker-Schaltung angeschlossen sind;

**dadurch gekennzeichnet,** daß die Schaltung weiter umfaßt ein zwischen den Emittern der Transistoren der ersten Differentialverstärker-Schaltung (1) angeschlossenes Impedanzelement (3, 33; 26, 27);

eine erste Konstantstromquelle ($I_0$, $I_x$) zum Zuführen eines auswählbaren Stromes, die zwischen einem gemeinsamen Emitter für die Transistoren der zweiten Differentialverstärker-Schaltung (2, 22) und einer ersten Spannungsquelle ($V_1$) angeschlossen ist;

einen zwischen jeder Eingangsklemme der zweiten Differentialverstärker-Schaltung (2) und der ersten Spannungsquelle ($V_1$) angeschlossenen Transistor ($Q_9$, $Q_{10}$), wobei jedem der Transisto-

ren ($Q_9$, $Q_{10}$) von einer zweiten Spannungsquelle ($V_2$, $V_3$) eine Basis-Vorspannung zugeführt wird.

9. Variable Impedanz-Schaltung nach Anspruch 8, bei der:

das Impedanzelement ein kapazitives Element (3) ist; die erste Konstantstromquelle ausgelegt ist, auswählbaren Strom $I_o$ dem gemeinsamen Emitter der Transistoren der zweiten Differentialverstärker-Schaltung (22) zuzuleiten; und

eine zweite Konstantstromquelle ausgelegt ist, auswählbaren Strom $I_1$ zwischen den Emittern der Transistoren der ersten Differentialverstärker-Schaltung (1) zuzuführen;

wodurch die Impedanz der Eingangsklemmen der Impedanz-Schaltung proportional zu dem Verhältnis der Stromwerte $I_o$ und $I_1$ der ersten bzw. zweiten Konstantstromquelle geändert werden kann.

10. Variable Impedanz-Schaltung nach Anspruch 8, bei der:

das Impedanzelement ein Widerstandselement (26, 27) ist;

die erste Konstantstromquelle ausgelegt ist, aus-wählbaren Strom $I_x$ dem gemeinsamen Emitter der Transistoren der zweiten Differentialverstärker-Schaltung (2) zuzuleiten; und

eine zweite Konstantstromquelle ausgelegt ist, auswählbaren Strom $I_o$ zwischen den Emittern der Transistoren der ersten Differentialverstärker-Schaltung (1) zuzuleiten;

wodurch die Impedanz der Eingangsklemme der Impedanz-Schaltung proportional zu dem Ver-hältnis der Stromwerte $I_x$ und $I_o$ der ersten bzw. zweiten Konstantstromquelle geändert werden kann.

**Revendications**

1. Circuit à impédance variable comportant:

des premier et second circuits amplificateurs différentiels (1, 2, 8, 9) possédant chacun une paire de bornes d'entrée et une paire de bornes de sortie, chaque circuit amplificateur différentiel étant constitué d'une paire de dispositifs actifs ($Q_1$, $Q_2$ ; $Q_3$, $Q_4$ ; 24, 25), dans lesquels des éléments d'impédance (3, 4, 5, 7) sont montés entre lesdites paires de dispositifs actifs, lesdits dispositifs actifs étant des transistors ou des amplificateurs opérationnels ;

des moyens pour relier la paire de bornes d'entrée dudit premier circuit amplificateur différentiel (1, 8) à la paire de bornes de sortie dudit second circuit amplificateur différentiel (2, 9) ; et

des moyens pour relier la paire de bornes d'entrée dudit second circuit amplificateur différentiel (2, 9) à la borne de sortie dudit premier circuit amplificateur différentiel (1, 8) ; dans lesquels

les bornes d'entrée (A, A') du circuit d'impédance sont connectées entre les bornes d'entrée des éléments actifs dudit premier circuit amplificateur différentiel (1, 8) ;

caractérisé en ce que

les éléments d'impédance sont soit :

un élément capacitif (3) dans le premier circuit amplificateur différentiel (1, 8) et un premier élément résistif (5) de valeur ohmique pouvant être choisie R dans le second circuit amplificateur différentiel (2, 9) ; soit

un premier élément résistif (7) de valeur ohmique pouvant être choisie R dans le premier circuit amplificateur différentiel (1, 8) et un élément capacitif (4) dans le second circuit amplificateur différentiel (2, 9) ;

et caractérisé en ce que

un second élément résistif (6) de valeur ohmique pouvant être choisie R3 est connecté entre les bornes d'entrée des éléments actifs dudit second circuit amplificateur différentiel (2, 9) ;

de telle sorte que l'impédance desdites bornes d'entrée est capacitive et est définie par le rapport R3/R des valeurs ohmiques desdits premier et second éléments résistifs.

2. Circuit à impédance variable selon la revendication 1, dans lequel lesdits dispositifs actifs dudit premier circuit amplificateur différentiel sont des amplificateurs opérationnels.

3. Circuit à impédance variable selon la revendication 1, dans lequel lesdites paires de dispositifs desdits premier et second circuits amplificateurs différentiels sont des paires de transistors ($Q_1$, $Q_2$ ; $Q_3$, $Q_4$).

4. Circuit à impédance variable selon la revendication 3, dans lequel lesdits éléments d'impédance (3, 4, 5, 7) sont montés entre les émetteurs des-dites paires de transistors ($Q_1$, $Q_2$ ; $Q_3$, $Q_4$).

5. Circuit à impédance variable selon l'une quelconque des revendications précédentes, dans lequel une première source à courant constant pour dé-livrer un courant réglable $I_0$ est connectée entre la paire de dispositifs actifs dudit second circuit amplificateur différentiel.

6. Circuit à impédance variable selon la revendication 5, dans lequel un circuit de conversion courant-courant (20) est connecté entre les premier et second circuits amplificateurs différentiels (1, 2), ledit circuit de conversion courant-courant comportant un troisième circuit amplificateur différentiel constitué d'une paire de transistors ($Q_5$, $Q_6$) et d'une seconde source à courant constant pour délivrer un courant réglable $I_2$ reliée à l'émetteur commun de ladite paire de transistors ($Q_5$, $Q_6$) dudit troisième circuit amplificateur différentiel, les bases du transistor du troisième circuit amplificateur différentiel étant reliées à la paire de bornes de sortie du second circuit amplificateur différentiel (2), et les connecteurs des transistors du troisième circuit amplificateur différentiel étant reliés à la paire de bornes d'entrée du premier circuit amplificateur différentiel (1) ;

de telle sorte que l'impédance des bornes d'entrée du circuit d'impédance est définie par le rapport des valeurs ohmiques (R3/R) desdits premier et second éléments résistifs et par le rapport des valeurs de courant ($I_2/I_0$) desdites première et seconde sources à courant constant.

7.  Agencement à impédance variable comportant des premier et second circuits à impédance variable (100, 101) chacun selon l'une quelconque des revendications précédentes, comportant en outre des moyens pour connecter la borne d'entrée d'un des dispositifs actifs ($Q_1$, $Q_2$) du premier circuit amplificateur différentiel (1) dudit premier circuit à impédance variable (100) à la borne d'entrée d'un des dispositifs actifs ($Q_1$, $Q_2$) du premier circuit amplificateur différentiel (1) dudit second circuit à impédance variable (101).

8.  Circuit à impédance variable comportant :

des premier et second circuits amplificateurs différentiels (1 ; 2, 22) constitués chacun d'une paire de transistors ($Q_1$, $Q_2$ ; $Q_3$, $Q_4$) et possédant une paire de bornes d'entrée et une paire de bornes de sortie ;

des moyens pour relier la paire de bornes d'entrée dudit premier circuit amplificateur différentiel (1) à la paire de bornes de sortie dudit second circuit amplificateur différentiel (2, 22) ; et

des moyens pour relier la paire de bornes d'entrée dudit second circuit amplificateur différentiel (2, 22) à la paire de bornes de sortie dudit premier amplificateur différentiel (1) ;

dans lequel les bornes d'entrée du circuit à impédance variable sont connectées entre les bornes de base des transistors ($Q_1$, $Q_2$) du premier circuit amplificateur différentiel ;

caractérisé en ce que ledit circuit comporte en outre un élément d'impédance (3, 33 ; 26, 27) monté entre les émetteurs des transistors dudit premier circuit amplificateur différentiel (1) ;

une première source à courant constant ($I_0$, $I_x$) pour délivrer un courant réglable, connectée entre un émetteur commun des transistors dudit second circuit amplificateur différentiel (2, 22) et une première source de tension ($V_1$);

un transistor ($Q_9$, $Q_{10}$) connecté entre chaque borne d'entrée dudit second circuit amplificateur différentiel (2) et la première source de tension ($V_1$), dans lequel une polarisation de base est délivrée à chacun desdits transistors ($Q_9$, $Q_{10}$) à partir d'une seconde source de tension ($V_2$, $V_3$).

9.  Circuit à impédance variable selon la revendication 8, dans lequel :

ledit élément d'impédance est un élément capacitif (3) ;

ladite première source à courant constant est conçue pour délivrer un courant réglable $I_0$ à l'émetteur commun des transistors dudit second circuit amplificateur différentiel (22) ; et

une seconde source à courant constant est conçue pour délivrer un courant réglable $I_1$ entre les émetteurs des transistors dudit premier circuit amplificateur différentiel (1) ;

de telle sorte que l'impédance desdites bornes d'entrée du circuit d'impédance peut être modifiée proportionnellement au rapport des valeurs de courant $I_0$ et $I_1$ des première et seconde sources à courant constant.

10.  Circuit à impédance variable selon la revendication 8, dans lequel :

ledit élément d'impédance est un élément résistif (26, 27) ;

ladite première source à courant constant est conçue pour délivrer un courant réglable $I_x$ à l'émetteur commun du transistor dudit second circuit amplificateur différentiel (2) ; et

une seconde source à courant constant est conçue pour délivrer un courant réglable $I_0$ entre les émetteurs des transistors du premier circuit amplificateur différentiel (1) ;

de telle sorte que l'impédance des bornes d'entrée du circuit d'impédance peut être modifiée proportionnellement au rapport des valeurs de courant $I_x$ et $I_0$ des première et seconde sources à courant constant.

F I G. 1

F I G. 2

FIG. 3

FIG. 4

# F I G. 5

# F I G. 6

F I G. 7

F I G. 8

FIG. 9

FIG. 10

FIG. 11

18

# FIG.12 PRIOR ART

FIG.13 PRIOR ART

FIG.14 PRIOR ART